# FASCICULE DE BREVET EUROPEEN

(11) **EP 0 978 941 B1**
(45) Date de publication et mention de la délivrance du brevet: **13.08.2008**
(21) Numéro de dépôt: 99410095.6
(22) Date de dépôt: 04.08.1999
(51) Int. Cl.: H03K 3/57, F23Q 3/00

(54) **Circuit de production d'arcs électriques**
Elektrische Bogenerzeugungsschaltung
Electric arc generation circuit

(30) Priorité: 04.08.1998 FR 9810167
(43) Date de publication de la demande: 09.02.2000
(73) Titulaire: STMicroelectronics S.A., 92120 Montrouge (FR)
(72) Inventeur: Bremond, André, 37270 Veretz (FR); Merceron, Philippe, 37210 Vernon (FR)
(74) Mandataire: de Beaumont, Michel

(56) Documents cités:
- GB-A- 2 130 646
- US-A- 3 894 273
- US-A- 4 507 533
- US-A- 4 965 860

## Description

La présente invention concerne les circuits de production d'arcs électriques. Plus particulièrement, la présente invention concerne les circuits dans lesquels de tels arcs sont produits à partir d'une tension alternative.

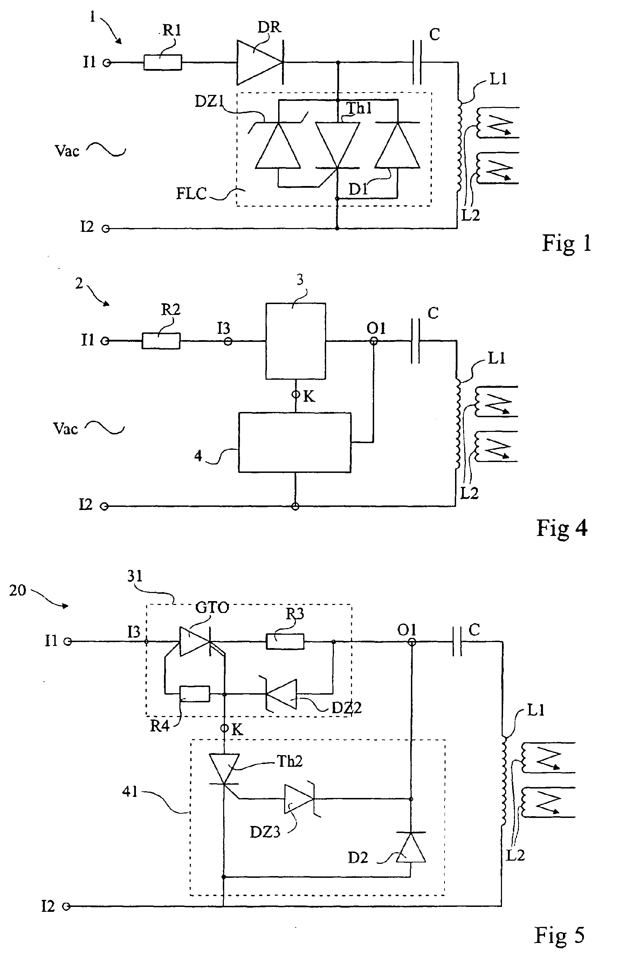

La figure 1 illustre un exemple classique d'un circuit 1 de production d'arcs électriques propres à enflammer un gaz combustible, par exemple, dans une enceinte industrielle, ou dans une application domestique à un four à gaz, aux feux de cuisson d'une gazinière, ou à un allume-gaz indépendant. Le circuit 1 comporte deux bornes d'entrée I1 et I2 propres à recevoir une tension alternative d'alimentation Vac, par exemple la tension du secteur, de typiquement 220 volts à 50 Hz (ou 110 volts à 60 Hz). Le circuit 1 comprend, en série entre ses bornes I1 et I2, une résistance R1, une diode DR, un condensateur C et un enroulement primaire L1 d'un transformateur d'isolement comportant un ou plusieurs enroulements secondaires L2. À chacun des enroulements secondaires L2 du transformateur est associée une paire d'électrodes (non représentées). Chaque paire est située à un emplacement où un arc électrique est nécessaire, et ses électrodes sont faiblement espacées. Le circuit 1 comporte également, en parallèle avec le condensateur C et l'enroulement L1, un moyen FLC d'organisation de la charge et de la décharge du condensateur C. Le moyen FLC comprend, en antiparallèle, un thyristor Th1 à gâchette de cathode et une diode D1. La gâchette du thyristor Th1 est reliée à l'anode d'une diode Zener DZ1 dont la cathode est reliée à l'anode du thyristor Th1.

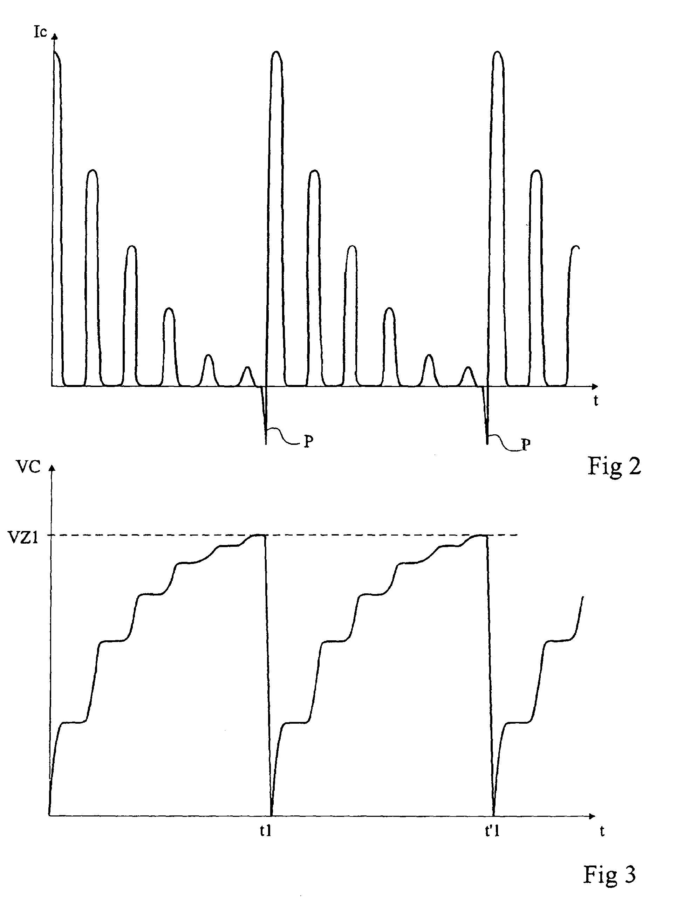

Le fonctionnement du circuit 1 est décrit ci-après en relation avec les figures 2 et 3. La figure 2 illustre l'allure du courant Ic dans le condensateur C (figure 1). La figure 3 illustre schématiquement l'allure de la tension Vc aux bornes du condensateur.

Pendant les alternances positives de la tension Vac, le condensateur C se charge par l'intermédiaire de la diode DR et de la résistance R1. Plus précisément, la diode DR est passante quand la tension Vac est supérieure au niveau de charge Vc et le condensateur se charge. Dans tous les autres cas et, en particulier, pendant les alternances négatives de la tension Vac, la diode DR est bloquée. Pendant toute la charge du condensateur C, le thyristor Th1 est bloqué.

On notera qu'il faut plusieurs alternances positives de la tension Vac pour atteindre le niveau de charge requis, contrôlé de la façon décrite ci-après.

En effet, comme l'illustre la figure 3, tant que la tension Vc n'a pas atteint un niveau VZ1, le condensateur complète sa charge à chaque alternance. Cela se traduit, pour l'allure de la tension Vc, par une croissance par paliers correspondant à plusieurs alternances et, pour le courant Ic, par une diminution exponentielle des amplitudes maximales des pics de courant de charge au fil des alternances.

Quand la tension Vc atteint le seuil VZ1, par exemple de 250 volts, fixé par la diode Zener DZ1, cette dernière entre en avalanche (instant tl) et un courant de gâchette amorce le thyristor Th1. La diode DR se bloque et le condensateur se décharge brutalement dans l'enroulement primaire L1 par l'intermédiaire du thyristor qui sert alors de "composant de roue libre". Cette décharge crée dans l'enroulement primaire une croissance (pic négatif P avec les conventions de signe de la figure 2) du courant qui est reproduite au secondaire (par conservation de l'énergie magnétique). Côté secondaire, cette variation de courant se traduit par une surtension aux bornes de chaque enroulement L2 et donc entre les électrodes correspondantes, ce qui provoque l'apparition d'un arc électrique entre ces électrodes.

Le thyristor Th1 se bloque par disparition du courant qui le traverse, c'est-à-dire quand le condensateur est complètement déchargé. La diode D1 sert alors de diode de roue libre pour évacuer le courant lié à l'énergie réactive du transformateur tant que la diode DR n'est pas redevenue passante.

Ensuite, au début de l'alternance positive suivant cette décharge (cet arc), la diode DR redevient passante et le condensateur C recommence à se charger de la façon décrite précédemment jusqu'à un instant t1' auquel la tension Vc atteint de nouveau le niveau VZ1.

L'intervalle de temps (t1'-t1) entre deux décharges (arcs) correspond au temps de charge du condensateur jusqu'au seuil VZ1. Ce temps dépend donc classiquement du niveau de la tension d'alimentation Vac.

Cela constitue un inconvénient de ce type de circuits de production d'arcs électriques, la tension d'alimentation Vac, par exemple la tension du secteur, pouvant être sujette à des variations aléatoires de niveau. De telles variations provoquent des variations de la fréquence d'émission des arcs électriques.

Si le niveau de la tension Vac augmente, le condensateur se charge plus vite, la fréquence des arcs augmente et peut devenir trop élevée, typiquement de presque 10 Hz, et on est confronté à des problèmes de compatibilité électromagnétique.

Ce problème de fréquence intervient également dans des circuits où, pour d'autres raisons, on cherche à synchroniser les arcs sur la fréquence de la tension Vac. Un inconvénient est alors que la fréquence des arcs est égale à la fréquence (50 Hz) de la tension Vac, ce qui est trop élevé. C'est le cas, par exemple, de l'allume-gaz décrit dans le document GB-A-2 130 646.

Si le niveau de la tension Vac diminue, le condensateur se charge plus lentement, la fréquence des arcs diminue et peut devenir trop basse, typiquement inférieure à 2 Hz, ce qui provoque une accumulation des gaz à enflammer. Une telle accumulation peut poser des problèmes de sécurité.

Or les compagnies de distribution électrique ne garantissent pas une tension constante. La tension peut varier, par exemple de ± 20% par rapport à une tension secteur de 220 volts à 50 Hz. Une valeur de 170 volts correspond alors à une fréquence d'arcs de 1,6 Hz, et une valeur de 250 volts correspond à une fréquence d'arcs de 6 Hz.

Un autre inconvénient d'un circuit classique tel que celui représenté en figure 1 est que le seuil VZ1 de la diode Zener DZ1 est susceptible de subir des variations liées aux dispersions technologiques et aux dérives en fonctionnement (température, etc.). Or, ce seuil conditionne la périodicité des arcs.

Le brevet américain N° 3 894 273 décrit un circuit de production d'arcs électriques pour un allume-gaz dans lequel un condensateur de stockage est utilisé pour stocker une charge prédéterminée à décharger à travers le primaire d'un transformateur d'isolement.

La présente invention vise à proposer un nouveau circuit de production d'arcs électriques dans lequel la vitesse de charge du condensateur soit toujours suffisante pour permettre la production d'arcs électriques à une fréquence suffisamment élevée pour éviter l'accumulation de gaz.

La présente invention vise également à proposer un circuit de production d'arcs électriques à une fréquence suffisamment basse pour ne pas perturber son environnement par des perturbations électromagnétiques.

Plus généralement, la présente invention vise à proposer un circuit de production d'arcs électriques de fréquence approximativement régulière.

Pour atteindre ces objets, la présente invention prévoit un circuit de production d'arcs électriques à partir d'une tension alternative, comportant des moyens pour rendre la fréquence des arcs électriques sensiblement indépendante d'éventuelles variations d'amplitude de la tension alternative tout en étant inférieure à la fréquence de la tension alternative.

Selon un mode de réalisation de la présente invention, les arcs sont produits au moyen d'un transformateur d'isolement dont l'enroulement primaire est connecté en série avec un condensateur, et le circuit comporte des moyens pour organiser la charge et la décharge du condensateur, la charge s'effectuant à un courant sensiblement constant.

Selon un mode de réalisation de la présente invention, les moyens pour organiser la charge et la décharge du condensateur comprennent une source de courant constant et un bloc de commutation.

Selon un mode de réalisation de la présente invention, la source de courant et le bloc de commutation sont réalisés sous la forme d'un unique circuit intégré.

Selon un mode de réalisation de la présente invention, la source de courant comporte, sur le chemin de charge du condensateur, un premier élément résistif associé à un moyen fixant la tension à ses bornes.

Selon un mode de réalisation de la présente invention, le moyen fixant la tension aux bornes du premier élément résistif est constitué d'une diode Zener ayant un seuil faible devant la tension alternative, et la source de courant comporte un moyen pour limiter le courant d'avalanche dans la diode Zener.

Selon un mode de réalisation de la présente invention, le moyen de limitation de courant constitue en outre un moyen de commande d'un commutateur en série avec le premier élément résistif.

Selon un mode de réalisation de la présente invention, le bloc de commutation comprend un commutateur commandable sur le chemin de décharge du condensateur, un moyen de détection du niveau de charge du condensateur, et un composant de roue libre.

Selon un mode de réalisation de la présente invention, la tension alternative est basse fréquence.

La présente invention vise aussi un allume-gaz électrique, comportant un circuit de production d'arcs du type ci-dessus.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 3 qui ont été décrites précédemment sont destinées à illustrer l'état de la technique et le problème posé ;
la figure 4 représente, de façon très schématique, un mode de réalisation d'un circuit de production d'arcs électriques selon la présente invention ;
la figure 5 représente un premier mode de réalisation détaillé du circuit de la figure 4 ;
les figures 6 et 7 illustrent, sous forme de chronogrammes, le fonctionnement du circuit représenté en figure 5 ;
la figure 8 représente un deuxième mode de réalisation détaillé d'une source de courant de charge du condensateur du circuit de la figure 4 ; et
les figures 9 et 10 représentent des deuxième et troisième modes de réalisation détaillés d'un bloc de commutation du circuit de la figure 4.

Les mêmes éléments ont été désignés par les mêmes références aux différentes figures. Pour des raisons de clarté, seuls les éléments nécessaires à la compréhension de l'invention ont été représentés aux figures et seront décrits par la suite.

La figure 4 représente, de façon schématique, un mode de réalisation d'un circuit 2 de production d'arcs électriques selon l'invention. Le circuit 2 comprend, en série entre deux bornes d'entrée I1 et I2 une résistance R2, une source de courant 3, un condensateur C et un enroulement primaire L1 d'un transformateur d'isolement. Les bornes Il et I2 sont destinées à recevoir une tension alternative d'alimentation Vac, par exemple la tension du secteur. La source de courant 3 selon l'invention comporte une borne I3 d'entrée, une borne O1 de sortie et une borne K de commande. Le circuit 2 comprend également selon l'invention un bloc 4 de commutation, connecté en parallèle avec le condensateur C et l'enroulement L1 (entre les bornes O1 et I2). L'ensemble de la source 3 et du bloc 4 constitue un moyen d'organisation de la charge et de la décharge du condensateur C.

Une caractéristique de la présente invention est que la source 3 est une source de courant constant. Ainsi, selon l'invention, la charge du condensateur C est organisée à courant approximativement constant.

Un avantage de la présente invention est que, en chargeant le condensateur à courant approximativement constant, on rend approximativement constante la durée (nombre d'alternances de l'alimentation) nécessaire à sa charge et, par voie de conséquence, la fréquence des arcs électriques.

La figure 5 représente un premier mode de réalisation détaillé d'un circuit 20 de production d'arcs électriques selon la présente invention.

La source de courant constant (3, figure 4) est un circuit 31 comprenant un thyristor ouvrable par la gâchette de cathode (GTO). L'anode du thyristor GTO constitue la borne d'entrée I3 du circuit 31. La cathode du thyristor GTO est reliée à une première borne d'une résistance R3 de valeur relativement faible dont la deuxième borne constitue la borne de sortie O1 du circuit 31. La gâchette d'anode du thyristor GTO est reliée, par l'intermédiaire d'une résistance R4 de valeur relativement élevée, à sa gâchette de cathode qui constitue la borne de commande K du circuit 31. La borne K est également reliée à la cathode d'une diode Zener DZ2 dont l'anode est connectée à la borne de sortie O1 du circuit 31 et dont la tension d'avalanche a une valeur faible devant la tension Vac.

Le bloc de commutation (4, figure 4) est, selon le mode de réalisation de la figure 5, constitué d'un circuit 41 à trois bornes, comprenant un thyristor Th2 à gâchette de cathode. L'anode du thyristor Th2 est reliée à la borne de commande K du circuit 31. Sa cathode est reliée à la borne I2. La gâchette du thyristor Th2 est connectée à l'anode d'une diode Zener DZ3 dont la cathode est reliée à la borne O1. Le circuit 41 comprend également une diode de roue libre D2 entre les bornes O1 et I2.

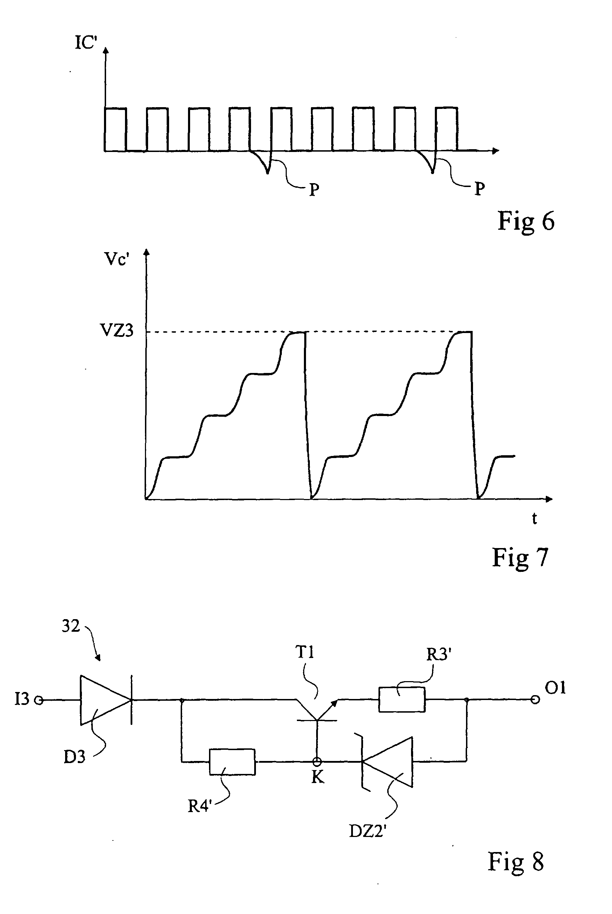

Les figures 6 et 7 illustrent le fonctionnement du circuit de la figure 5. La figure 6 représente l'allure du courant Ic' dans le condensateur C. La figure 7 représente l'allure de la tension Vc' aux bornes du condensateur C pour ce courant Ic'.

Au début de chaque alternance positive de la tension Vac, la fermeture du thyristor GTO se fait de la façon suivante. Un courant circule dans son anode, sa gâchette d'anode, la résistance R4, sa gâchette de cathode et sa cathode. Quand ce courant atteint le courant d'amorçage du thyristor GTO, ce dernier devient passant. Pendant cette phase, le thyristor Th2 est bloqué et la diode DZ2 est polarisée en inverse (en dessous de sa valeur seuil). Le retard à la fermeture du thyristor GTO par rapport au zéro de tension Vac dépend de la valeur de la résistance R4.

Une fois le thyristor GTO rendu passant, le courant Ic' dans le condensateur C correspond à la somme des courants dans la résistance R3 et dans la diode DZ2. En effet, comme la diode DZ2 a une valeur seuil faible (par exemple une dizaine de volts) devant la tension Vac, elle régule la tension entre les bornes O1 et K à une valeur sensiblement constante correspondant à cette valeur seuil. Par conséquent, le courant dans la résistance R3 est sensiblement constant. Comme la valeur de la résistance R3 est faible devant la valeur de la résistance R4, elle voit passer la plus grande partie du courant de charge. Ainsi, plus la résistance R4 est de valeur importante, plus le courant Ic' est stable. Toutefois, on doit choisir une valeur acceptable pour la mise en conduction du thyristor GTO le plus tôt possible après le début de l'alternance positive et pour ne pas entraîner une trop forte dissipation dans la résistance R4.

Quand la tension Vc' atteint une tension de seuil VZ3 fixée par la diode Zener DZ3, apparaît un courant dans la gâchette du thyristor Th2 qui s'amorce. Alors, le thyristor GTO du circuit 31 s'ouvre par extraction des porteurs par sa gâchette de cathode. Le condensateur C se décharge alors (pics négatifs P en figure 6) par l'intermédiaire de la diode DZ2 et du thyristor Th2 dans l'enroulement primaire L1 du transformateur pour produire des arcs électriques côté secondaire (par conservation de l'énergie magnétique, d'une manière classique).

On notera que le circuit 20 a un fonctionnement mono-alternance, le thyristor GTO étant bloqué pendant les alternances négatives.

A titre d'exemple particulier de réalisation, pour une tension Vac de 220 volts à 50 Hz, on pourra choisir, pour les composants du circuit 20 de la figure 5, les valeurs suivantes :
C = 1 µF ;
R3 = 5 kΩ ;
R4 = 75 kΩ ;
VZ2 = 10 V ; et
VZ3 = 250 V.

Avec de telles valeurs, la fréquence des arcs est respectivement de 3,9 Hz et 5,1 Hz pour des tensions Vac de 170 V et 250 V.

Pour une tension Vac de 110 volts à 60 Hz, on pourra choisir les valeurs suivantes :
C = 1 µF ;
R3 = 10 kΩ ;
R4 = 75 kΩ ;
VZ2 = 10 V ; et
VZ3 = 120 V.

En fonction de la fréquence souhaitée pour les arcs (décharges du condensateur C), la tension du secteur Vac, d'une fréquence de 50 ou 60 Hz, est appliquée directement ou par l'intermédiaire d'un pont redresseur, entre les bornes I1 et I2 (figure 1). Dans ce dernier cas, les alternances négatives sont également utilisées pour charger le condensateur, et la fréquence des arcs est doublée.

La figure 8 représente un deuxième mode de réalisation d'une source de courant 32 à trois bornes I3, O1, K utilisable dans le circuit de la présente invention tel que représenté en figure 4. Une telle source 32 comporte un transistor bipolaire T1 du type NPN dont le collecteur est relié à la cathode d'une diode D3 dont l'anode constitue la borne d'entrée I3. L'émetteur du transistor T1 est relié à une première borne d'une résistance R3' dont la deuxième borne constitue la borne de sortie O1. La base du transistor T1 constitue la borne de commande K. Le collecteur et la base du transistor T1 sont interconnectés par une résistance R4'. La base du transistor T1 est reliée à la cathode d'une diode Zener DZ2' de faible valeur dont l'anode est reliée à la borne de sortie O1. Le fonctionnement de la source de courant 32 est sensiblement similaire à celui du circuit 31 (figure 5).

Pendant les alternances positives, la diode DZ2' joue un rôle similaire à celui de la diode DZ2 (figure 5) en maintenant sensiblement constante et égale à sa tension seuil la tension aux bornes de la résistance R3' (à la tension base-émetteur du transistor T1 près). Par conséquent, le courant dans la résistance R3' est sensiblement constant et le courant de charge du condensateur est approximativement constant (fixé par le courant dans les résistances R3' et R4'). La diode D3 sert à protéger le transistor T1 qui ne tient pas la tension en inverse.

A titre d'exemple particulier de réalisation, pour une tension Vac de 220 volts à 50 Hz, on pourra choisir, pour les composants du circuit 32, les valeurs suivantes :
R3' = 5,6 kΩ ;
R4' = 620 kΩ ; et
VZ2' = 10 V.

Le premier mode de réalisation de la source de courant constant 31 illustré en figure 5 constitue cependant un mode de réalisation préféré. Il présente en particulier l'avantage que le thyristor GTO du circuit 31 de dimensions plus faibles que le transistor T1 du circuit 32 a le même gain. Un autre avantage du circuit 31 est qu'il évite le recours à une diode (D3, circuit 32) pour tenir la tension lorsque le thyristor GTO est ouvert.

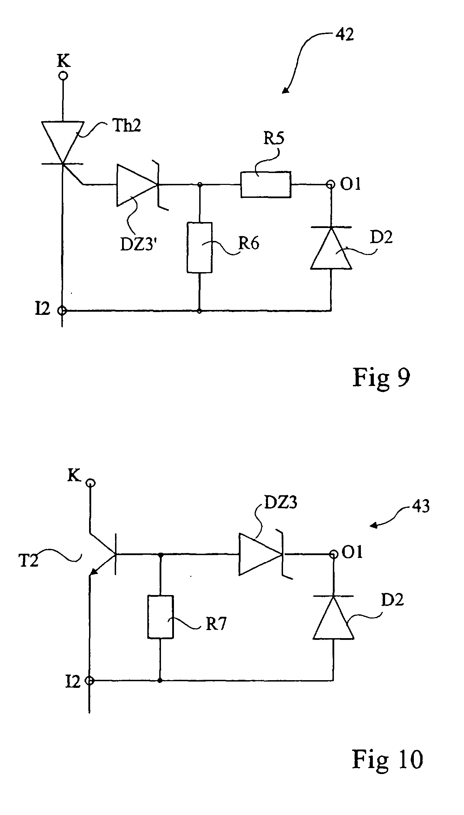

La figure 9 représente un deuxième mode de réalisation du bloc 4 de commutation du circuit de la figure 4. Selon ce mode de réalisation, ce bloc de commutation 42 est sensiblement similaire au circuit 41 de la figure 5. Toutefois, la cathode d'une diode Zener DZ3' (remplaçant la diode DZ3 du circuit 41) n'est pas reliée à la borne O1, mais est connectée au point-milieu d'un pont de résistances R5, R6. Plus précisément, une résistance R5 est connectée entre la cathode de la diode DZ3' et la borne O1, alors qu'une résistance R6 est connectée entre la cathode de la diode DZ3' et la borne I2. Un tel pont de résistances a pour objet de permettre l'utilisation d'une diode Zener DZ3' dont le seuil est plus bas que celui de la diode DZ3 du circuit 41 (figure 5). Cela présente l'avantage de rendre le seuil de déclenchement du bloc de commutation moins sensible aux variations de la tension d'alimentation Vac. En outre, cela facilite l'intégration du circuit.

A titre d'exemple particulier de réalisation, pour une tension Vac de 220 volts à 50 Hz, on pourra choisir, pour les composants du circuit 42, les valeurs suivantes :
R5 = 330 kΩ ;
R6 = 30 kΩ ; et
VZ3' = 10 V.

La figure 10 représente un troisième mode de réalisation du bloc 4 du circuit de la figure 4. Selon ce mode de réalisation, ce bloc de commutation 43 diffère du circuit 41 de la figure 5 en ce qu'il comprend un transistor bipolaire NPN T2 remplaçant le thyristor Th2. Dans ce cas, le collecteur du transistor T2 est relié à la borne de commande K, son émetteur à la borne I2, et sa base à la anode de la diode Zener DZ3. On veillera à prévoir une résistance R7 de polarisation entre l'émetteur du transistor T2 et sa base.

Un avantage de la présente invention est qu'elle permet de rendre la fréquence des arcs électriques approximativement indépendante de variations éventuelles de la tension d'alimentation.

Un autre avantage de la présente invention est qu'elle utilise un faible nombre de composants et est donc particulièrement économique.

Un autre avantage de la présente invention est que tous les composants du circuit (source de courant et bloc de commutation) sont intégrables dans un même circuit intégré.

On notera que la fréquence des arcs électriques peut être modifiée, soit en changeant la valeur du condensateur C, soit en changeant la valeur du courant constant délivré par la source de courant.

A titre de variante non représentée, le bloc de commutation (4, figure 4) est constitué d'un moyen classique d'organisation de la charge et de la décharge du condensateur, par exemple, un circuit FLC tel que représenté en figure 1. Dans ce cas, la borne de commande K de la source de courant (3, figure 4 ; 31, figure 5 ; 32, figure 8) selon la présente invention n'est pas connectée à ce bloc d'organisation de la charge et reste en l'air.

Un avantage de cette variante est qu'elle permet de modifier simplement les circuits existants, qui comprennent déjà l'élément FLC, en ajoutant uniquement une source de courant constant selon l'invention.

Bien entendu, la présente invention est susceptible de diverses variantes et modifications qui apparaîtront à l'homme de l'art. En particulier, bien que l'invention ait été décrite dans le cas particulier d'un allume-gaz, elle est utilisable dans tout type de dispositif industriel ou domestique dans lequel la production d'arcs électriques est nécessaire. De plus, on notera que la réalisation de la résistance R4 ou R4' sous forme intégrée sera, de préférence, faite au moyen d'un transistor à effet de champ à jonction (JFET). Cela présente l'avantage de bénéficier d'une caractéristique courant-tension non linéaire qui présente une asymptote en courant. Ainsi, le courant dans la diode DZ2 (ou DZ2') en inverse est limité et, par conséquent, la variation du courant de charge du condensateur. En outre, bien que cela n'ait pas été représenté, on notera que le circuit est autonome (comme les circuits classiques), c'est-à-dire que la production d'arcs est provoquée simplement par la fourniture de la tension Vac entre les bornes I1 et I2. En pratique, cette fourniture est, bien entendu, commandée par un moyen de commutation classique.

## Revendications

1. Circuit (2, 20) de production d'arcs électriques à partir d'une tension alternative (Vac) au moyen d'un transformateur d'isolement dont l'enroulement primaire (L1) est connecté en série avec un condensateur (C), **caractérisé en ce qu'**il comporte :
sur le chemin de charge du condensateur (C), une source de courant (31, 32) comportant un premier élément résistif (R3, R3') associé à un moyen (DZ2, DZ2') fixant la tension à ses bornes ; et
un bloc de commutation (41, 42, 43) comportant un commutateur (Th2, T2) commandable sur le chemin de décharge du condensateur (C), un moyen (DZ3, DZ3') de détection du niveau de charge du condensateur (C), et un composant (D2) de roue libre.

2. Circuit selon la revendication 1, **caractérisé en ce que** la source de courant (3, 31, 32) et le bloc de commutation (4, 41, 42, 43) sont réalisés sous la forme d'un unique circuit intégré.

3. Circuit selon la revendication 1 ou 2, **caractérisé en ce que** le moyen fixant la tension aux bornes du premier élément résistif (R3, R3') est constitué d'une diode Zener (DZ2, DZ2') ayant un seuil faible devant la tension alternative (Vac), et **en ce que** la source de courant (31, 32) comporte un moyen (R4, R4') pour limiter le courant d'avalanche dans la diode Zener.

4. Circuit selon la revendication 3, **caractérisé en ce que** le moyen de limitation de courant (R4, R4') constitue en outre un moyen de commande d'un commutateur (GTO, T1) en série avec le premier élément résistif (R3, R3').

5. Circuit selon l'une quelconque des revendications 1 à 4, **caractérisé en ce que** la tension alternative (Vac) est basse fréquence.

6. Allume-gaz électrique, **caractérisé en ce qu'**il comporte un circuit (2, 20) de production d'arcs selon l'une quelconque des revendications 1 à 5.

## Claims

1. A circuit (2, 20) of electric arc generation from an A.C. voltage (Vac), by means of an isolation transformer, the primary winding (L1) of which is connected in series with a capacitor (C), **characterized in that** it comprises:
on the charge path of the capacitor (C), a current source (31, 32) comprising a first resistive element (R3, R3') associated with a means (DZ2, DZ2') setting the voltage thereacross; and
a switching block (41, 42, 43) including a controllable switch (Th2, T2) on the discharge path of the capacitor (C), a means (DZ3, DZ3') of detection of the charge level of the capacitor (C), and a free wheel component (D2).

2. The circuit of claim 1, **characterized in that** the current source (3, 31, 32) and the switching block (4, 41, 42, 43) are made in the form of a single integrated circuit.

3. The circuit of claim 1 or 2, **characterized in that** the means setting the voltage across the first resistive element (R3, R3') is formed of a Zener diode (DZ2, DZ2') having a low threshold with respect to the A.C. voltage (Vac), and the current source (31, 32) includes a means (R4, R4') for limiting the avalanche current in the Zener diode.

4. The circuit of claim 3, **characterized in that** the current limiting means (R4, R4') further is a means of control of a switch (GTO, T1) in series with the first resistive element (R3, R3').

5. The circuit of any of claims 1 to 4, **characterized in that** the A.C. voltage (Vac) is a low frequency voltage.

6. An electric gas lighter, **characterized in that** it includes the electric arc generation circuit (2, 20) of any of claims 1 to 5.

## Patentansprüche

1. Schaltung (2, 20) zur Erzeugung eines Lichtbogens aus einer Wechselspannung (Vac) mittels eines Isolationstransformators, dessen primäre Wicklung (L1) in Reihe mit einem Kondensator (C) geschaltet ist, **dadurch gekennzeichnet, dass** sie aufweist:
eine Stromquelle (31, 32) auf dem Aufladepfad des Kondensators (C), die ein erstes Widerstandselement (R3, R3') aufweist, das einem Mittel (DZ2, DZ2') zugeordnet ist, welches die Spannung dorthindurch einstellt; und
einen Umschaltblock (41, 42, 43), umfassend einen steuerbaren Schalter (Th2, T2) auf dem Entladepfad des Kondensators (C), ein Mittel (DZ3, DZ3') zur Erkennung des Ladungspegels des Kondensators (C) und eine Freilaufkomponente (D2).

2. Schaltung nach Anspruch 1, **dadurch gekennzeichnet, dass** die Stromquelle (3, 31, 32) und der Umschaltblock (4, 41, 42, 43) in der Form einer einzigen integrierten Schaltung ausgebildet sind.

3. Schaltung nach Anspruch 1 oder 2, **dadurch gekennzeichnet, dass** das Mittel, das die Spannung über dem ersten Widerstandselement (R3, R3') einstellt, aus einer Zener-Diode (DZ2, DZ2') gebildet ist, die einen niedrigen Schwellwert bezüglich der Wechselspannung (Vac) aufweist, und dass die Stromquelle (31, 32) ein Mittel (R4, R4') zum Begrenzen des Avalanche-Stroms in der Zener-Diode aufweist.

4. Schaltung nach Anspruch 3, **dadurch gekennzeichnet, dass** das Strombegrenzungsmittel (R4, R4') ferner ein Mittel zur Steuerung eines Schalters (GTO, T1) in Reihe mit dem ersten Widerstandselement (R3, R3') ist.

5. Schaltung nach einem der Ansprüche 1 bis 4, **dadurch gekennzeichnet, dass** die Wechselspannung (Vac) eine Niederfrequenzspannung ist.

6. Elektrischer Gasanzünder, **dadurch gekennzeichnet, dass** er die Lichtbogenerzeugungsschaltung (2, 20) nach jedem der Ansprüche 1 bis 5 aufweist.
